# EUROPEAN PATENT SPECIFICATION

(11) **EP 2 990 861 B1**
(45) Date of publication and mention of the grant of the patent: **04.12.2019**
(21) Application number: 13863668.3
(22) Date of filing: 18.10.2013
(51) Int. Cl.: G02F 1/1335, G02B 5/22

(54) **DISPLAY SUBSTRATE, DISPLAY DEVICE COMPRISING SAME, AND DISPLAY SUBSTRATE MANUFACTURING METHOD**
ANZEIGESUBSTRAT, ANZEIGEVORRICHTUNG DAMIT UND VERFAHREN ZUR HERSTELLUNG DES ANZEIGESUBSTRATS
SUBSTRAT D'AFFICHAGE, DISPOSITIF D'AFFICHAGE LE COMPRENANT ET PROCÉDÉ DE FABRICATION DE SUBSTRAT D'AFFICHAGE

(30) Priority: 24.04.2013 CN 201310146136
(43) Date of publication of application: 02.03.2016
(73) Proprietor: BOE Technology Group Co., Ltd., Beijing 100015 (CN)
(72) Inventor: ZHANG, Wenlin, Beijing 100176 (CN); ZHOU, Weifeng, Beijing 100176 (CN)
(74) Representative: Klunker IP Patentanwälte PartG mbB
(86) International application number: PCT/CN2013/085490
(87) International publication number: WO 2014/173093

(56) References cited:
- CN-A- 1 598 623
- CN-A- 1 641 421
- CN-A- 101 029 994
- CN-A- 103 235 443
- JP-A- 2011 209 350
- KR-A- 20050 052 690
- US-A- 5 501 900
- US-A1- 2010 225 858

## Description

### FIELD

The present invention relates to a display substrate, a display device and a method of manufacturing the display substrate.

### BACKGROUND

With a decrease of manufacturing cost and improvement of manufacturing process of a display panel, the application of the display panel becomes wider.

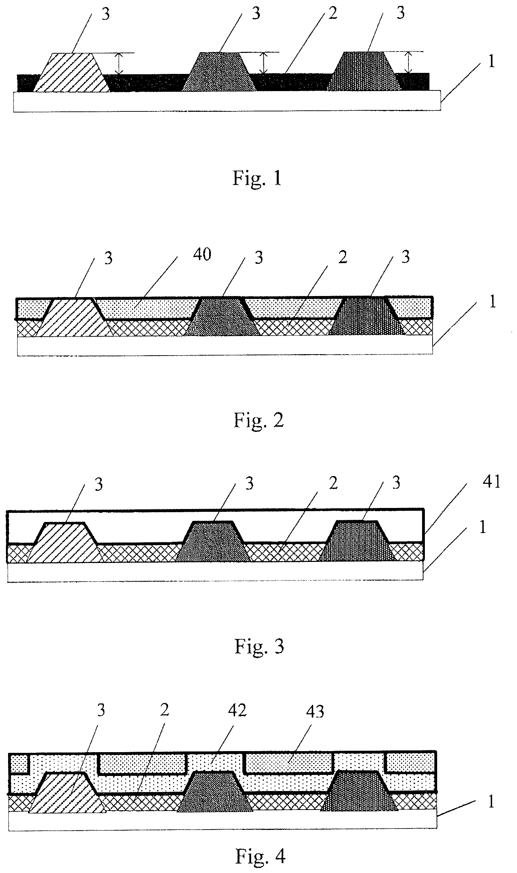

The display panel generally consists of a display substrate. The display substrate generally at least comprises a base substrate 1, a black matrix formed on the base substrate 1, and color filter 3 formed on the base substrate 1 and disposed in pixel regions defined by the black matrix 2. The color filter 3 normally comprises a red resin layer, a green resin layer and a blue resin layer. The color filter 3 and the black matrix 2 are arranged alternately, as illustrated in Fig. 1.

In a manufacturing method of a conventional display substrate, at first, patterns of a black matrix 2 is formed on a surface of a base substrate 1, and then a red resin layer, a green resin layer and a blue resin layer are deposited in sequence, hence a color filter 3 is finally formed. However, in the manufacturing processes, it is hard to control a height of the color filter 3 to be equal to a height of the black matrix. Normally, the color filter 3 is made higher than the black matrix 2 and a height difference is produced between the color filter 3 and the black matrix 2, such that a surface of the color filter 3 is not smooth, as illustrated in Fig. 1.

The surface smoothness of the display substrate is very important to image displaying quality. The height difference between the black matrix 2 and the color filter 3 would be higher if other films were deposited on the black matrix 2 and the color filter 3, such that the surface of the display substrate is not smooth and product yield decreases. And further, in the successive processes, when rubbing an alignment layer, non-uniform rubbing occurs at the regions with the height difference such that the display device has a poor display quality.

US 2010/225858A1 discloses a color filter substrate comprising first black matrixes; color resin units; and a protection layer. Each of the color resin units is formed between two adjacent first black matrixes, the protection layer is formed on the first black matrixes and the color resin units, second black matrixes are formed, each corresponding to one first black matrix, on the protection layer for blocking reflected light from the first black matrixes from entering TFT channel regions on an array substrate to be provided to oppose the color filter substrate.

KR 10-2005-0052690 discloses a color filter substrate comprising a substrate; a black matrix formed in a predetermined region defined on the substrate; red, green and blue color filters partially overlapped with the black matrix; and an overcoat layer formed on the black matrix and the color filter. A predetermined thickness of the overcoat layer formed on the stepped portion which is formed by an overlap between the black matrix and the color filter, is removed through a diffraction exposure process during exposure of a mask.

### SUMMARY

It is one object of the present invention to provide a display substrate so as to solve the technical problem introduced by a color filter with an unsmooth surface which leads to product yield decrease and low display quality.

The object is achieved by the features of the respective independent claims. Further embodiments are defined in the respective dependent claims.

In one aspect, embodiments of the disclosure provide a display substrate comprising a base substrate, a black matrix and a color filter formed on the base substrate. The color filter and the black matrix are arranged alternately with a height difference between the black matrix and the color filter. The display substrate further comprising a planarizing layer disposed on the black matrix or on both the black matrix and the color filter, and configured to planarize the height difference between the black matrix and the color filter. The photoresist is an opaque photoresist, and the opaque photoresist is formed on the black matrix and have an upper surface flushed with an upper surface of the color filter.

In another aspect, embodiments of the disclosure provide a display device comprising the display substrate mentioned above.

In still another aspect, embodiments of the disclosure provide a method of manufacturing a display substrate. The method comprises: forming a black matrix and a color filter alternately on a base substrate; forming a planarizing layer on the base substrate on which the black matrix and the color filter are formed. The planarizing layer is configured to minimize a height difference between the black matrix and the color filter. The planarizing layer is made of a transparent resin and a photoresist; forming a planarizing layer on the base substrate on which the black matrix and the color filter are formed comprises: forming a transparent resin on the base substrate on which the black matrix and the color filter are formed; forming a photoresist on the transparent resin; depending on the height difference between the black matrix and the color filter, exposing and developing the photoresist with a gray tone mask so as to form a fifth photoresist region corresponding to the color filter region and a sixth photoresist region corresponding to the black matrix region; wherein the photoresist in the fifth photoresist region is completely removed, the photoresist in the sixth photoresist region partially or completely remains, an upper surface of the sixth photoresist region corresponding to the black matrix region is flushed with an upper surface of the transparent resin corresponding to the color filter.

In the display substrate according to embodiments of the disclosure, the display device comprising the display substrate, and the display substrate manufactured by the method for manufacturing a display substrate according to embodiments of the disclosure, a planarizing layer is formed on the black matrix or on both the black matrix and the color filter so as to minimize the height difference between the black matrix and the color filter. Methods according to embodiments of the disclosure effectively improve surface smoothness of the color filter, increase product yield and improve the display quality.

### BRIEF DESCRIPTION OF THE DRAWINGS

In order to clearly illustrate the technical solution of the invention, the drawings of embodiments of the invention and examples helpful to understand the invention will be briefly described in the following; it is obvious that the described drawings are only related to some embodiments of the disclosure and thus are not limitative of the disclosure.
Fig. 1 is a schematic view of a conventional display substrate;
Fig. 2 is a schematic view of a display substrate according to an embodiment of the invention;
Fig. 3 is a schematic view of another display substrate according to an example helpful to understand the invention; and
Fig. 4 is a schematic view of still another display substrate obtainable by a manufacturing method according to an embodiment of the invention.

### DETAILED DESCRIPTION

In order to make objects, technical details and advantages of the disclosure apparent, the technical solutions will be described in a clearly and fully understandable way in connection with the drawings related to embodiments of the invention and to examples helpful to understand the invention.

Embodiments of the invention provide a display substrate according to appended independent claim 1. A planarizing layer is formed of an opaque photoresist on the black matrix so as to planarize a height difference between the black matrix and the color filter. Such planarizing layer minimizes the height difference between the black matrix and the color filter, and effectively improves surface smoothness of the color filter.

### First Embodiment

As illustrated in Fig. 1, a display substrate according to a first embodiment of the disclosure comprises a base substrate 1, a black matrix 2 formed on the base substrate 1, and a color filter 3 formed on the base substrate 1. The black matrix and the color filter have a height difference. The display substrate further comprises a planarizing layer disposed on the black matrix 2 or on both the black matrix 2 and the color filter 3, so as to planarize the height difference between the black matrix and the color filter 3.

Further, the planarizing layer in the first embodiment of the disclosure for planarizing the height difference between the black matrix and the color filter 3 is made of a photoresist. The planarizing layer can be formed by a simple lithography process, thus simplifying the manufacturing process.

In the embodiment, the planarizing layer is made of the photoresist, and the display substrate has a structure illustrated in Fig. 2. The display substrate according to the embodiment of the disclosure comprises a base substrate 1, a black matrix 2 formed on the base substrate 1, and the color filter 3 formed on the base substrate 1 and having a height difference with respect to the black matrix 2. A planarizing layer 40 is disposed on the black matrix 2, and an upper surface of the planarizing layer 40 is flushed with an upper surface of the color filter 3.

The photoresist comprises an opaque photoresist. As the planarizing layer is disposed on the black matrix 2 in the embodiment, transmissivity of the planarizing layer will not affect transmissivity of the display substrate. Thus, the photoresist 40 for the planarizing layer in the embodiment adopts an opaque photoresist.

In the display substrate according to the embodiment, a planarizing layer made of an opaque photoresist is formed on the black matrix and the upper surface of the planarizing layer is flushed with the upper surface of the color filter. Thus, the height difference between the black matrix and the color filter can be minimized, and further, the surface smoothness of the color filter can be improved effectively.

### First Example helpful to understand the invention

In the example helpful to understand the invention; a transparent photoresist is used to make the planarizing layer in the display substrate, and the transparent photoresist is disposed on both the color filter and the black matrix. Fig. 3 is a schematic view of a display substrate according to the example. The display substrate comprises a base substrate 1, a black matrix 2 formed on the base substrate 1, a color filter 3 formed on the base substrate 1 and having a height difference with respect to the black matrix 2. The display substrate further comprises a planarizing layer 41 disposed on both the black matrix 2 and the color filter 3. An upper surface of the planarizing layer 41 is a plane, that is to say, a portion of the planarizing layer 41 corresponding to the black matrix 2 and a portion of the planarizing layer 41 corresponding to the color filter 3 have different layer thickness. Thus, the height difference between the black matrix 2 and the color filter 3 is minimized. The planarizing layer 41 is made of a transparent photoresist.

In the display substrate according to the example helpful to understand the invention, the planarizing layer made of transparent photoresist is formed on both the black matrix and the color filter, and an upper surface of the planarizing layer is a plane. The transparent planarizing layer minimizes the height difference between the black matrix and the color filter and improves the surface smoothness of the color filter without affecting the transmissivity of the display substrate.

It should be understood that in the example helpful to understand the invention, the planarizing layer can be made of a transparent resin instead of the photoresist, and can also achieve the object mentioned above.

### Second Example helpful to understand the invention;

As illustrated in Fig. 4, in the display substrate according to the example helpful to understand the invention, the planarizing layer consists of a transparent resin portion 42 and a photoresist portion 43. The transparent resin portion 42 covers the black matrix 2 and the color filter 3, the photoresist portion 43 covers the portion of transparent resin corresponding to the region of the black matrix 2. An upper surface of the photoresist portion 43 is flushed with an upper surface of the portion transparent resin portion 42 corresponding to the color filter.

It should be understood that the transparent resin 42 in the example can be made of a transparent organic resin material, a transparent inorganic resin material or any other materials capable of achieving the objects of the disclosure.

The planarizing layer according to the example comprises a transparent resin portion and a photoresist portion, and has a double layer structure. The height difference between the black matrix and the color filter is increased by the transparent resin, and then, based on the increased height difference, a photoresist portion of the planarizing layer is formed by means of gray tone exposure and development so as to minimize the height difference. In this manner, a layer thickness of the photoresist portion is precisely controlled. Thus, the technical problem such as product yield decrease and low display quality due to t the height difference between the color filter and the black matrix of the display substrate is avoided.

### Second Embodiment

The second embodiment of the disclosure provides a display device which comprises a display substrate according to the first embodiment, and other structures of the display device are the same as conventional ones, and will not be repeated herein.

The display device according to the embodiment can be a liquid crystal panel, a liquid crystal display device, a liquid crystal TV, an organic light-emitting diode (OLED) display panel, an OLED TV, a cell phone, a palm computer, a digital photo frame and the like.

In the display substrate comprised in the display device according to the embodiment, a planarizing layer is formed on the black matrix or on both the black matrix and the color filter so as to planarize the height difference between the black matrix and the color filter. The planarizing layer can minimize the height difference between the black matrix and the color filter and effectively improve the surface smoothness of the color filter. Thus, the product yield is increased and the display quality is improved.

### Third example helpful to understand the invention

The third example helpful to understand the invention provides a method of manufacturing a display substrate. The method comprises the following steps: Step S101, providing a base substrate; Step S102, forming a black matrix and a color filter on the base substrate; and Step S103, forming a planarizing layer on the base substrate on which the black matrix and the color filter are formed.

In one implementation, in the step S103 of the example, a planarizing layer for planarizing a height difference between the black matrix and the color filter is formed on the black matrix. The planarizing layer has an upper surface flushed with an upper surface of the color filter so as to minimize the height difference between the black matrix and the color filter.

In another implementation, in the step S103 of the example, a planarizing layer for planarizing the height difference between the black matrix and the color filter is formed on both the black matrix and the color filter, and a portion of the planarizing layer corresponding to the black matrix and a portion of the planarizing layer corresponding to the color filter have different layer thicknesses. In such a case, the upper surface of the planarizing layer disposed on the black matrix and the color filter is a plane, and can minimize the height difference between the black matrix and the color filter.

In the example, after forming a black matrix and a color filter on the base substrate, the method further comprises a step of forming a planarizing layer on the black matrix or on both the black matrix and the color filter. The planarizing layer is configured for planarizing the height difference between the black matrix and the color filter. The planarizing layer can improve surface smoothness of the color filter effectively. Thus, the product yield is increased and the display quality is improved.

### Fourth example helpful to understand the invention

In the fourth example helpful to understand the invention, a photoresist is used to form a planarizing layer on the black matrix or on both the black matrix and the color filter by means of lithography during manufacturing a display substrate, so as to improve surface smoothness of the color filter and improving image displaying quality. Here, only the difference between this fourth example and the third example helpful to understand the invention will be specifically described and the common features between the present embodiment and the fifth embodiment will be omitted.

In the present example, a photoresist is adopted to form the planarizing layer and the adopted photoresist is a transparent photoresist or an opaque photoresist. For example, the step S103 for forming the planarizing layer comprises the following steps.

Step S103a, a photoresist is formed on the base substrate on which the black matrix and the color filter formed.

For example, the photoresist can be formed on the black matrix and the color filter by methods such as coating, deposition and the like.

Step S103b, the photoresist formed in the step S103a is exposed by means of a gray tone mask according to the height difference between the black matrix and the color filter.

For example, different degrees of exposure will have different development result for the photoresist during the development. Thus, in order to minimize the height difference between the black matrix and the color filter, the photoresist on the black matrix and the photoresist on the color filter are exposed differently using a gray tone mask according to the height difference between the black matrix and the color filter, such that the photoresist on the black matrix and the photoresist on the color filter are dissolved differently in the development. Thus, the remaining photoresist after dissolution minimizes the height difference between the black matrix and the color filter as illustrated in Fig. 1.

Step S103c, the photoresist exposed in the step S103b is developed, and a first photoresist region and a second photoresist are formed.

For example, the color filter is higher than the black matrix in the example. In order to avoid affecting the transmissvity of the display panel, the photoresist at regions corresponding to the color filter on the base substrate is completely removed and the photoresist at regions corresponding to the black matrix on the base substrate remains completely or partially.

Further, the photoresist exposed in the step S103b is developed so as to form a first photoresist region corresponding to the color filter and a second photoresist region corresponding to the black matrix. The photoresist in the first photoresist region is removed completely, and the photoresist in the second photoresist region remains completely or partially, and the upper surface of the second photoresist region is flushed with the upper surface of the color filter. Thus, the completely or partially remaining photoresist in the second photoresist region corresponding to the black matrix is used to minimize the height difference between the black matrix and the color filter. Therefore, the product yield is increased and the image display quality is improved.

In the method for manufacturing a display substrate according to the this example helpful to understand the invention, according to the height difference between the black matrix and the color filter, the photoresist on the color filter is completely removed and the photoresist corresponding to the black matrix remains completely or partially by a lithography process with a gray tone mask. The completely or partially remaining photoresist corresponding to the black matrix minimizes the height difference between matrix and the color filter. Thus, the product yield is increased and the image display quality is improved.

### Fifth example helpful to understand the invention

A transparent photoresist is adopted for making a planarizing layer in this example, and the step S103a for forming a planarizing layer comprises the following steps, for example.

Step S103d, a transparent photoresist is formed on the base substrate on which the black matrix and the color filter formed.

In this example, a transparent photoresist is formed on the base substrate on which the black matrix and the color filter formed by means of a coating, deposition and the like.

Step S103e, according to the height difference between the black matrix and the color filter, the transparent photoresist formed in the step S103d is exposed with a gray tone mask.

Step S103f, the photoresist exposed in the step S103e is developed so as to form a third photoresist region and a fourth photoresist region.

For example, in the example, the photoresist in third photoresist region corresponding to the black matrix region remains completely or partially, and the photoresist in the fourth photoresist region corresponding to the color filter region remains partially, and the upper surface of the third photoresist region corresponding to the black matrix region is flushed with the fourth photoresist region corresponding to the color filter region.

In the embodiment, as the photoresist corresponding to the black matrix region and corresponding to the color filter region is not completely removed in subsequent processes, the photoresist can be cured, and then the cured photoresist is mechanically polished such that the upper surface of the photoresist corresponding to the black matrix region is flushed with the upper surface of the photoresist corresponding to the color filter region.

In the method of manufacturing a display substrate according to the example, according to the height difference between the black matrix and the color filter, a portion of the transparent photoresist on the color filter remains and a portion of the transparent photoresist on the black matrix remains completely or partially by a lithography process with a gray tone mask, such that the upper surface of the third photoresist region corresponding to the black matrix region is flushed with the upper surface of the fourth photoresist region corresponding to the color filter region, so as to minimize the height difference between the black matrix and the color filter. Thus, the product yield is increased and the image display quality is improved.

### Third Embodiment

The third embodiment of the disclosure further provides a method of manufacturing a display substrate. Here, only difference between the third embodiment and the third example helpful to understand the invention, is specifically described and the common features is omitted. The step S103 for forming a planarizing layer comprises following steps for example.

Step S103g, a transparent resin is formed on the base substrate on which the black matrix and the color filter are formed.

For example, in the third embodiment, a transparent resin is formed on the base substrate formed with the black matrix and the color filter by means of coating, deposition and the like. The transparent resin can be an organic resin, an inorganic resin, or any other material capable of achieving objects of the embodiment of the disclosure.

In the third embodiment, after the transparent resin is formed on the black matrix and the color filter, a portion of the surface of the resultant transparent resin corresponding to the regions of the black matrix and of the color filter having a height difference is not smooth either, due to the height difference between the black matrix and the color filter region. And further, as the transparent resin is formed on both the black matrix and the color filter, the height difference between the black matrix and the color filter is further increased by the transparent resin.

Step S103h, a photoresist is formed on the transparent resin.

For example, in the third embodiment, the photoresist formed on the transparent resin can be a positive photoresist or a negative photoresist. And moreover, the photoresist can be a transparent photoresist or an opaque photoresist.

Step S103i, based on the height difference between the transparent resin corresponding to the black matrix region and the transparent resin corresponding to the color filter region, the photoresist coated in step S103h is exposed in different degrees with a gray tone mask and developed, thus, a fifth photoresist region corresponding to the color region and a sixth photoresist region corresponding to the black matrix region are formed.

In the third embodiment, the photoresist in the fifth photoresist region corresponding to the color region is completely removed, and the photoresist in the sixth photoresist region corresponding to the black matrix region remains partially or completely. The upper surface of the sixth photoresist region corresponding to the black matrix region is flushed with the upper surface of the transparent resin corresponding to the color filter.

It should be noted that, it is not necessary to completely remove the photoresist corresponding to the color filter region if the photoresist used in examples helpful to understand the invention, does not affect the transmissivity of the display panel, and the photoresist can remain as long as the upper surface of the photoresist eventually formed corresponding to the black matrix region is in a same plane as the upper surface of the photoresist formed corresponding to the color filter region. That is to say, a portion of the photoresist in the fifth photoresist region corresponding to the color filter region partially remains and a portion of the photoresist in the sixth photoresist region corresponding to the black matrix remains partially or completely, the upper surface of the sixth photoresist region corresponding to the black matrix is in a same plane as the upper surface of the fifth photoresist region corresponding to the color filter region.

In examples helpful to understand the invention, a layer of transparent resin is formed on the black matrix and the color filter in advance, a corresponding height difference is generated between the transparent resin corresponding to the black matrix region and the transparent resin corresponding to the color filter, and this height difference is increased with respect to the height difference between the black matrix and the color filter. The photoresist in various regions are exposed in different degrees and developed, and thus layer thicknesses of the photoresist can be accurately controlled. Therefore, the product yield is increased and the image displaying quality is improved.

The photoresist used in the third embodiment of the disclosure can be a positive photoresist or a negative photoresist. The photoresist is exposed in different ways depending on the properties of the photoresist. For example, when a negative photoresist is used, if a photoresist completely remaining region needs to be formed, the photoresist in the corresponding region is completely exposed; if a photoresist partially remaining region needs to be formed, the photoresist in the corresponding region is partially exposed; and if a photoresist completely removed region needs to be formed, the photoresist in the corresponding region is not exposed. If a positive photoresist is used, it should be exposed in contrary manners.

## Claims

1. A display substrate comprising:
a base substrate (1),
a black matrix (2) and a color filter (3) formed on the base substrate (1), the color filter (3) and the black matrix (2) arranged alternately with a height difference between the black matrix (2) and the color filter (3),
wherein the display substrate further comprising a planarizing layer (40) configured to minimize the height difference between the black matrix (2) and the color filter (3);
**characterized in that** the planarizing layer (40) is made of an opaque photoresist formed on the black matrix (2) and has an upper surface flushed with the upper surface of the color filter (3).

2. A display device, **characterized in that** the display device comprises the display substrate according to claim 1.

3. A method of manufacturing a display substrate, comprising the following steps of:
forming a black matrix (2) and a color filter (3) on a base substrate (1),
forming a planarizing layer (40) on the base substrate (1) on which the black matrix (2) and the color filter (3) are formed, the planarizing layer (40) configured to minimize a height difference formed between the black matrix (2) and the color filter (3);
the method being **characterized in that**
the planarizing layer (40) is made of a transparent resin and a photoresist;
the step of forming a planarizing layer (40) on the base substrate (1) on which the black matrix (2) and the color filter (3) are formed comprises:
forming a transparent resin on the base substrate (1) on which the black matrix (2) and the color filter (3) are formed;
forming a photoresist on the transparent resin;
depending on the height difference between the black matrix (2) and the color filter (3), exposing and developing the photoresist with a gray tone mask so as to form a first photoresist region corresponding to the color filter region and a second photoresist region corresponding to the black matrix region;
wherein the photoresist in the first photoresist region is completely removed, the photoresist in the second photoresist region partially or completely remains, so that an upper surface of the second photoresist region corresponding to the black matrix region is flushed with the upper surface of the transparent resin corresponding to the color filter (3).

## Patentansprüche

1. Anzeige-Substrat mit:
einem Basissubstrat (1),
einer Schwarzmatrix (2) und einem Farbfilter (3), das auf dem Basissubstrat (1) gebildet ist, wobei das Farbfilter (3) und die Schwarzmatrix (2) abwechselnd mit einem Höhenunterschied zwischen der Schwarzmatrix (2) und dem Farbfilter (3) angeordnet sind,
wobei das Anzeigesubstrat weiter eine Planarisierungsschicht (40) aufweist, die konfiguriert ist, den Höhenunterschied zwischen der Schwarzmatrix (2) und dem Farbfilter (3) zu minimieren;
**dadurch gekennzeichnet, dass** die Planarisierungsschicht (40) aus einem opaken Fotolack hergestellt ist, der auf der Schwarzmatrix (2) gebildet ist, und eine obere Oberfläche aufweist, die mit der oberen Oberfläche des Farbfilters (3) fluchtet.

2. Anzeigevorrichtung **dadurch gekennzeichnet, dass** die Anzeigevorrichtung das Anzeigesubstrat gemäß Anspruch 1 aufweist.

3. Herstellungsverfahren eines Anzeigesubstrats mit den folgenden Schritten:
Bilden einer Schwarzmatrix (2) und eines Farbfilters (3) auf einem Basissubstrat (1),
Bilden einer Planarisierungsschicht (40) auf dem Basissubstrat (1), auf dem die Schwarzmatrix (2) und das Farbfilter (3) gebildet sind, wobei die Planarisierungsschicht (40) konfiguriert ist, die Höhendifferenz, die zwischen der Schwarzmatrix (2) und dem Farbfilter (3) gebildet ist, zu minimieren;
wobei das Verfahren **dadurch gekennzeichnet ist, dass**
die Planarisierungsschicht (40) aus einem transparenten Harz und einem Fotolack hergestellt ist;
der Schritt des Bildens einer Planarisierungsschicht (40) auf dem Basissubstrat (1), auf dem die Schwarzmatrix (2) und der Farbfilter (3) ausgebildet sind, aufweist:
Bilden eines transparenten Harzes auf dem Basissubstrat (1), auf dem die Schwarzmatrix (2) und der Farbfilter (3) gebildet sind;
Bilden eines Fotolacks auf dem transparenten Harz;
abhängig von der Höhendifferenz zwischen der Schwarzmatrix (2) und dem Farbfilter (3), Belichten und Entwickeln des Fotolacks mit einer Grautonmaske, um so eine erste Fotolackregion, die der Farbfilterregion entspricht, und eine zweite Fotolackregion, die der Schwarzmatrixregion entspricht, zu bilden;
wobei der Fotolack in der ersten Fotolackregion komplett entfernt wird, wobei der Fotolack in der zweiten Fotolackregion teilweise oder vollständig verbleibt, sodass eine obere Oberfläche der zweiten Fotolackregion, die der Schwarzmatrixregion entspricht, mit der oberen Oberfläche des transparenten Harzes, das dem Farbfilter (3) entspricht, fluchtet.

## Revendications

1. Substrat d'affichage comprenant :
un substrat de base (1) ;
une matrice noire (2) et un filtre couleur (3) qui sont formés sur le substrat de base (1), le filtre couleur (3) et la matrice noire (2) étant agencés en alternance selon une différence de hauteur entre la matrice noire (2) et le filtre couleur (3) ; dans lequel :
le substrat d'affichage comprenant en outre une couche de planarisation (40) qui est configurée de manière à ce qu'elle minimise la différence de hauteur entre la matrice noire (2) et le filtre couleur (3) ;
**caractérisé en ce que** la couche de planarisation (40) est réalisée en une résine photosensible opaque qui est formée sur la matrice noire (2) et elle comporte une surface supérieure à niveau avec la surface supérieure du filtre couleur (3).

2. Dispositif d'affichage, **caractérisé en ce que** le dispositif d'affichage comprend le substrat d'affichage selon la revendication 1.

3. Procédé de fabrication d'un substrat d'affichage, comprenant les étapes qui suivent constituées par :
la formation d'une matrice noire (2) et d'un filtre couleur (3) sur un substrat de base (1) ;
la formation d'une couche de planarisation (40) sur le substrat de base (1) sur lequel la matrice noire (2) et le filtre couleur (3) sont formés, la couche de planarisation (40) étant configurée de manière à ce qu'elle minimise une différence de hauteur qui est formée entre la matrice noire (2) et le filtre couleur (3) ;
le procédé étant **caractérisé en ce que** :
la couche de planarisation (40) est réalisée en une résine transparente et en une résine photosensible ;
l'étape de formation d'une couche de planarisation (40) sur le substrat de base (1) sur lequel la matrice noire (2) et le filtre couleur (3) sont formés comprend :
la formation d'une résine transparente sur le substrat de base (1) sur lequel la matrice noire (2) et le filtre couleur (3) sont formés ;
la formation d'une résine photosensible sur la résine transparente ;
en fonction de la différence de hauteur entre la matrice noire (2) et le filtre couleur (3), l'exposition et le développement de la résine photosensible à l'aide d'un masque de niveaux de gris de manière à former une première région de résine photosensible qui correspond à la région de filtre couleur et une seconde région de résine photosensible qui correspond à la région de matrice noire ; dans lequel :
la résine photosensible dans la première région de résine photosensible est complètement supprimée, la résine photosensible dans la seconde région de résine photosensible subsiste partiellement ou complètement de telle sorte qu'une surface supérieure de la seconde région de résine photosensible qui correspond à la région de matrice noire soit à niveau avec la surface supérieure de la résine transparente qui correspond au filtre couleur (3).
